# NEW EUROPEAN PATENT SPECIFICATION

(11) **EP 4 018 171 B2**
(45) Date of publication and mention of the opposition decision: **04.11.2026**
(45) Mention of the grant of the patent: 02.08.2023
(21) Application number: 20740358.5
(22) Date of filing: 24.06.2020
(51) Int. Cl.: G01M 5/00

(54) **A SYSTEM AND A METHOD FOR MONITORING MATERIAL FATIGUE**
SYSTEM UND VERFAHREN ZUR ÜBERWACHUNG DER MATERIALERMÜDUNG
SYSTÈME ET PROCÉDÉ DE SURVEILLANCE DE LA FATIGUE D'UN MATÉRIAU

(30) Priority: 21.08.2019 FI 20195690
(43) Date of publication of application: 29.06.2022
(73) Proprietor: Lappeenrannan-Lahden teknillinen yliopisto LUT, 53851 Lappeenranta (FI)
(72) Inventor: BJÖRK, Timo, 53851 Lappeenranta (FI); AHOLA, Antti, 53851 Lappeenranta (FI)
(74) Representative: Väänänen, Janne Kalervo
(86) International application number: PCT/FI2020/050452
(87) International publication number: WO 2021/032906

(56) References cited:
- WO-A1-2016/102968
- WO-A2-2006/116758
- CN-A- 105 600 682

## Description

### Field of technology

The disclosure relates generally to monitoring material fatigue. More particularly, the disclosure relates to a system and a method for monitoring fatigue of a mechanical structure. Furthermore, the disclosure relates to a computer program for monitoring fatigue of a mechanical structure.

### Background

In many cases, a mechanical structure is subjected to cyclic mechanical loading which may cause fatigue in materials of the mechanical structure. The mechanical structure can be for example a part of a working machine such as e.g. a crane, a part of a vehicle, or a part of some other device, or a whole device. If the above-mentioned cyclic mechanical loading is above a certain threshold, microscopic cracks will begin to form at stress concentrators such as for example surfaces, persistent slip bands "PSB", interfaces of constituents in a case of composites, and grain interfaces in a case of metals. After crack initiation, the crack will propagate, and eventually the mechanical structure will finally fracture. The shape of the mechanical structure will significantly affect the fatigue strength. For example, square holes and sharp corners will lead to elevated local stresses where fatigue cracks can initiate. Instead, round holes and smooth transitions and fillets will increase the fatigue strength of the mechanical structure. In welded metal structures, areas adjacent to welded joints are often critical since a local geometry and existence of high residual stress and welding deformations in welded joints are often suboptimal from the viewpoint of the fatigue strength.

An inherent challenge related to damages caused by fatigue is that the above-mentioned microscopic cracks are typically not recognized during a use of a mechanical structure. A further challenge is that the crack propagation will accelerate in accordance with an increasing crack length and therefore the mechanical structure may fracture even if the loading remains unchanged. Thus, in many cases, fatigue in materials of mechanical structures may cause expensive production shutdowns. Therefore, there is a need for techniques for monitoring fatigue in a mechanical structure during a lifetime of the mechanical structure.

The document WO 2016/102968 A1 discloses a method and a system for monitoring material fatigue.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In accordance with the present invention, there is provided new systems for monitoring fatigue of a mechanical structure that can be e.g. a part of a working machine such as e.g. a crane, a part of a vehicle, or a part of some other device, or a whole device.

Each of the systems according to the invention comprises memory equipment storing a database that contains predetermined response values each being associated with one of predetermined stress ranges, i.e. stress variation ranges, and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, where the upper limit corresponds to a predetermined survival probability of the mechanical structure.

The system further comprises processing equipment configured to:
- repeatedly update, for each of the above-mentioned response values, corresponding a stress history value expressing number of cycles occurred in a time-trend of the stress and having the predetermined stress range and the predetermined mean stress related to the response value under consideration, and
- repeatedly update a fatigue damage sum based on the response values and the stress history values related to the response values.

The fatigue damage sum expresses cumulated fatigue damage of the mechanical structure, and therefore the fatigue damage sum can be used for real-time fatigue monitoring during a lifetime of the mechanical structure. A system according to an advantageous embodiment of the invention is suitable for monitoring fatigue of a mechanical structure in real time and during usage of the mechanical structure.

It is worth noting that computations carried out for updating the above-mentioned fatigue damage sum are not necessarily carried out with stress values, but as well the computations can be carried out with values of another quantity related to the stress. For example, each response value can be associated with one of predetermined strain ranges and one of predetermined mean strains. The response value is however indirectly associated with one of predetermined stress ranges and one of predetermined mean stresses because the strain is related to the stress via a deterministic rule.

In accordance with the present invention, there is provided also new methods for monitoring fatigue of a mechanical structure. Each of the methods comprises:
- maintaining a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly updating, for each of the above-mentioned response values, corresponding a stress history value expressing number of cycles occurred in a time-trend of the stress and having the predetermined stress range and the predetermined mean stress related to the response value under consideration, and
- repeatedly updating a fatigue damage sum based on the response values and the stress history values related to the response values.

In accordance with the invention, there is provided also new computer programs for monitoring fatigue of a mechanical structure. Each of the computer programs comprises computer executable instructions for controlling programmable processing equipment to:
- retrieve data from a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly update, for each of the response values, a corresponding stress history value expressing number of cycles occurred in a time-trend of the stress and having the predetermined stress range and the predetermined mean stress related to the response value under consideration, and
- repeatedly update a fatigue damage sum based on the response values and the stress history values related to the response values.

In accordance with the invention, there is provided also new computer program products. Each of the computer program products comprises a non-volatile computer readable medium, e.g. a compact disc "CD", encoded with a computer program according to the invention.

The systems, methods, and computer programs according to the invention are described in accompanied independent claims.

Various exemplifying and non-limiting embodiments are described in accompanied dependent claims.

Exemplifying and non-limiting embodiments both as to constructions and to methods of operation, together with additional objects and advantages thereof, will be best understood from the following description of specific exemplifying embodiments when read in conjunction with the accompanying drawings.

The verbs "to comprise" and "to include" are used in this document as open limitations that neither exclude nor require the existence of also un-recited features. The features recited in the accompanied dependent claims are mutually freely combinable unless otherwise explicitly stated. Furthermore, it is to be understood that the use of "a" or "an", i.e. a singular form, throughout this document does not exclude a plurality.

### Brief description of the figures

Exemplifying and non-limiting embodiments and their advantages are explained in greater detail below in the sense of examples and with reference to the accompanying drawings, in which:
figure 1 shows a functional block diagram of a system according to an exemplifying and non-limiting embodiment for monitoring fatigue of a mechanical structure,
figures 2a and 2b illustrate exemplifying ways to visualize results obtained with a system according to an exemplifying and non-limiting embodiment, and
figure 3 shows a flowchart of a method according to an exemplifying and non-limiting embodiment for monitoring fatigue of a mechanical structure.

### Description of exemplifying and non-limiting embodiments

The specific examples provided in the description below should not be construed as limiting the scope and/or the applicability of the accompanied claims. Lists and groups of examples provided in the description are not exhaustive unless otherwise explicitly stated.

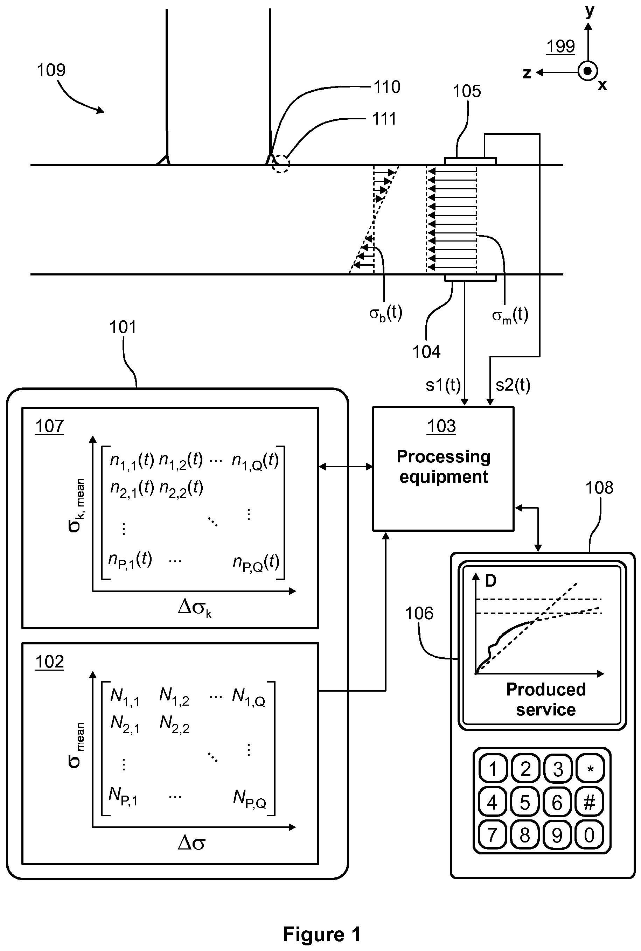

Figure 1 shows a functional block diagram of a system according to an exemplifying and non-limiting embodiment for monitoring fatigue of an exemplifying mechanical structure 109. In the exemplifying situation shown in figure 1, the mechanical structure 109 comprises a welded T-joint 110, and fatigue at an observation point 111 of the mechanical structure 109 is monitored. It is to be noted that the mechanical structure 109 is shown for illustrative purposes only, and the system illustrated in figure 1 is applicable with many different mechanical structures to be monitored.

The system comprises memory equipment 101 storing a database 102 that contains predetermined response values *N*_{1,1},..., *N*_{P,Q}. Each of the predetermined response values *N*_{1,1}, ..., *N*_{P,Q} is associated with one of predetermined stress ranges Δσ₁,..., Δσ_{,Q} and with one of predetermined mean stresses σ_{1,mean},..., σ_{P,mean}. Each response value expresses an upper limit for number of cycles of stress *σ*(*t*) at the observation point 111 of the mechanical structure 109 in a situation in which the cycles have the predetermined stress range Δσ and the predetermined mean stress σₘₑₐₙ related to the response value under consideration. The upper limit corresponds to a predetermined survival probability of the mechanical structure 109 in the above-described situation. Each of the predetermined response values *N*_{1,1}, ..., *N*_{P,Q} can be estimated based on the fatigue performance of the mechanical structure 109. In general, at the positive side, a sum of the mean stress and the amplitude i.e. the stress range/2, converted to nominal stress level, should not exceed the yield strength of material under consideration. The maximum allowable compressive nominal membrane stress, respectively, should not exceed the yield strength at the compressive side. In an exemplifying case where a thin and slender mechanical structure is under monitoring, the maximum allowable compressive stress related to the buckling capacities, such as plate buckling, flexural, or lateral buckling of columns, should not be exceeded.

Each response value *N_{k,q},* where *k* = 1, 2, ..., P and *q* = 1, 2, ..., Q can be computed for example according to the following equation: ${N}_{k , q} = \frac{{C}_{ref}}{{\left(\frac{Δ {σ}_{q}}{\sqrt{1 - {R}_{local}}}\right)}^{{m}_{ref}}} ,$ (1) where *C_{ref}* is a fatigue performance that is specific to the mechanical structure under consideration and corresponds to a selected survival probability, Δ*σ_{q}* is the stress range at the observation point of the mechanical structure, and *m_{ref}* is a model parameter i.e. the slope of the S-N curve e.g. 5.85. *R_{local}* is a local stress ratio at the observation point, e.g. a notch, of the mechanical structure: ${R}_{local} = \frac{{σ}_{mean} - Δ σ / 2}{{σ}_{mean} + Δ σ / 2} ,$ (2) where *σₘₑₐₙ* and Δ*σ* are the mean stress and the stress range, respectively, at the observation point of the mechanical structure, considering the material elastoplastic behavior.

The above-mentioned local stress ratio *R_{local}* and subsequently the response value *N_{k,q}* depend on, among others, material strength, residual stresses within the mechanical structure both in as-welded or post treated conditions, geometry and dimensions of the mechanical structure, welded joint and/or cut edge parameters, such as e.g. weld toe or root side geometry for a welded joint and surface quality for a cut edge.

Theoretical background related to the above-presented equations 1 and 2 can be found in the publication: Timo Nykänen and Timo Björk: Assessment of fatigue strength of steel buttwelded joints in as-welded condition - Alternative approaches for curve fitting and mean stress effect analysis, Lappeenranta University of Technology, Laboratory of Steel Structures, Marine Structures 44, 2015, pp. 288 - 310, Elsevier Ltd, and in the publication: Timo Nykänen and Timo Björk: A new proposal for assessment of the fatigue strength of steel buttwelded joints improved by peening under constant amplitude tensile loading, School of Energy Systems, Lappeenranta University of Technology, Wiley Publishing Ltd. Fatigue Fract Engng Mater Struct, 2016, 39, pp. 566-582. It is to be noted that the above-mentioned response values *N*_{1,1}, ..., *N*_{P,Q} can be obtained with any suitable method, and therefore the invention is not limited to any particular method for obtaining the response values *N*_{1,1}, ..., *N*_{P,Q}.

The above-mentioned mean stress considers advantageously the average stress level of external stress range and the effect of residual stresses. The third level, i.e. the tertiary, stress as notch stress level residual stresses are advantageously considered at notch stresses, and the secondary as structural level stresses are advantageously multiplied by notch factors. Also, the relaxation of the residual stresses can be considered, and the analysis can apply the relaxed stress values.

The system comprises processing equipment 103 configured to repeatedly update, for each of the above-mentioned response values *N*_{1,1}, ..., *N*_{P,Q}, a corresponding stress history value *n*_{1,1}(*t*), ..., *n*_{P,Q}(*t*) that expresses number of cycles which have occurred in the time-trend of the stress *σ*(*t*) and which have the predetermined stress range and the predetermined mean stress related to the response value under consideration. The stress history values *n*_{1,1}(*t*), ..., *n_{P,Q}*(*t*) are presented as functions of time t because their values develop along with the time. The update rate can be e.g. in the range from 0.01 Hz to 20 Hz. In other words, a time interval between successive updates of the stress history values *n*_{1,1}(*t*), ..., *n*_{P,Q}(*t*) can be from 50 millisecond to 100 seconds. In the exemplifying system illustrated in figure 1, the memory equipment 101 stores a database 107 that contains the stress history values *n*_{1,1}(*t*), ..., *n*_{P,Q}(*t*).

In a system according to an exemplifying and non-limiting embodiment, the processing equipment 103 is configured to run the Rainflow-counting algorithm to update the stress history values *n*_{1,1}(*t*), ..., *n*_{P,Q}(*t*) based on the time-trend of the stress *σ*(*t*) at the observation point 111 of the mechanical structure 109. The Rainflow-counting algorithm, also known as the "Rain-flow counting method", is commonly used in fatigue analyses and monitoring to reduce a spectrum of time-varying stress into a set of cycle counts corresponding to a given set of mean values and a given set of variation ranges. More detailed information about the Rainflow-counting algorithm can be found e.g. in the publication M. Matsuishi and T. Endo: *Fatigue of metals subjected to varying stress,* Japan Society of Mechanical Engineering 1968. It is to be noted that there are many cycle-counting algorithms for fatigue analyses and monitoring, and therefore the invention is not limited to any specific cycle-counting algorithm.

The processing equipment 103 is configured to repeatedly update a fatigue damage sum *D* based on the response values *N*_{1,1}, ..., *N*_{P,Q} and the stress history values *n*_{1,1}(*t*), ..., *n*_{P,Q}(*t*) related to the response values. The fatigue damage sum *D* expresses cumulated fatigue damage of the mechanical structure 109 and it can be used for estimating a remaining service producible by the mechanical structure. The update rate can be e.g. in the range from 0.01 Hz to 20 Hz. In other words, a time interval between successive updates of the fatigue damage sum *D* can be from 50 millisecond to 100 seconds.

In a system according to an exemplifying and non-limiting embodiment, the processing equipment 103 is configured to compute the fatigue damage sum *D* according to the Palmgren-Miner damage accumulation formula: $D = {\sum }_{\begin{matrix}i = 1 , P \\ j = 1 , Q\end{matrix}} \frac{{n}_{i , j} \left(t\right)}{{N}_{i , j}} .$ (3)

A system according to an exemplifying and non-limiting embodiment comprises a display element 106, and the processing equipment 103 is configured to control the display element 106 to show growth of the fatigue damage sum *D* as a function of cumulative service produced by the mechanical structure 109. The display element 106 can be e.g. a part of a user interface 108 of the system. The cumulative service produced by the mechanical structure 109 can be for example a cumulative service time, a cumulative distance traversed by a vehicle or another device comprising the mechanical structure, a cumulative mass of loads transferred or lifted by a device comprising the mechanical structure, a cumulative product of transferred mass and transfer distance e.g. ton-kilometers, or some other quantity indicative of the cumulative service produced by the device comprising the mechanical structure 109.

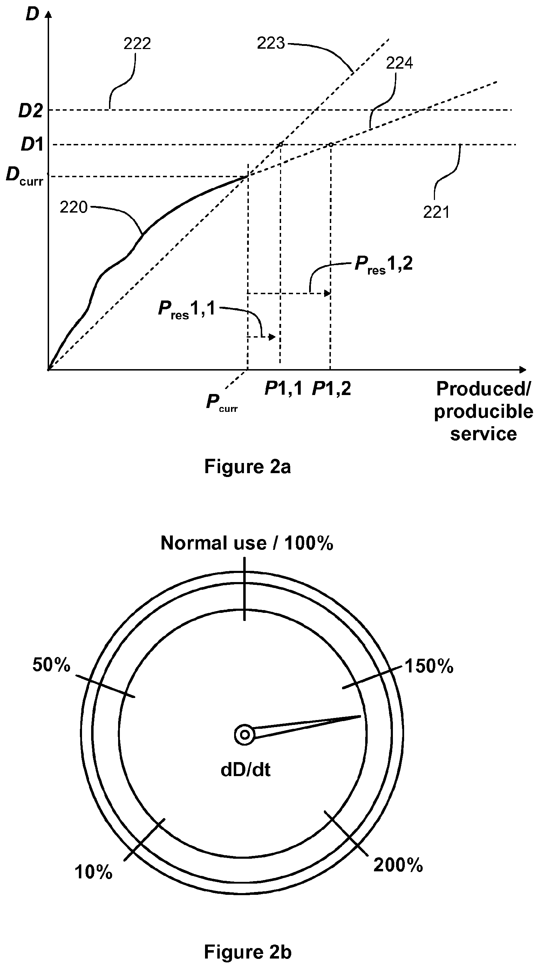

In a system according to an exemplifying and non-limiting embodiment, the processing equipment 103 is configured to compute an average growth rate of the fatigue damage sum *D.* In figure 2a, the average growth rate of the fatigue damage sum *D* is the slope of the line 223. The processing equipment 103 is configured to estimate a remaining service *P*ᵣₑₛ1,1 producible by the mechanical structure 109, e.g. a remaining service time, based on: i) a current value *D*_{curr} of the fatigue damage sum *D,* ii) the above-mentioned average growth rate of the fatigue damage sum, and iii) a value of the fatigue damage sum corresponding to a predetermined damage probability. In figure 2a, a line 221 represents a damage sum value D1 that corresponds to a first damage probability and a line 222 represents a damage sum value D2 that corresponds to a second damage probability greater than the first damage probability. In other words, the damage sum value D1 corresponds to a greater survival probability than the damage sum value D2.

In a system according to an exemplifying and non-limiting embodiment, the processing equipment 103 is configured to compute an estimate for an instantaneous growth rate d*D*/d*t* of the fatigue damage sum *D*. In figure 2a, the instantaneous growth rate of the fatigue damage sum *D* is the slope of the line 224. The instantaneous growth rate can estimated e.g. as (*D*(*t*₀) - *D*(*t*₋₁))/(*t*₀ - *t*₋₁), where *t*₀ is an update moment of the fatigue damage sum *D* and *t*₋₁ is an earlier update moment of the fatigue damage sum *D*. Numerical derivation of the kind mentioned above is however susceptible to disturbances, and thus it can be more advantageous to fit a polynomial or some other suitable curve with the time-discrete values of the fatigue damage sum *D* and thereafter to estimate the instantaneous growth rate with the derivative of the polynomial or some other suitable curve. The processing equipment 103 is configured to estimate a remaining service *P*ᵣₑₛ1,2 producible by the mechanical structure 109 based on: i) the current value *D*_{curr} of the fatigue damage sum, ii) the estimate of the instantaneous growth rate of the fatigue damage sum, and iii) a value of the fatigue damage sum, e.g. D1 or D2, corresponding to a predetermined damage probability.

Figure 2b presents a display dial that shows the instantaneous growth rate d*D*/d*t* of the fatigue damage sum *D.* The "Normal use / 100%" corresponds to a designed i.e. nominal instantaneous growth rate of the fatigue damage sum *D* so that the mechanical structure produces a designed cumulative service, e.g. a designed service time, if the instantaneous growth rate d*D*/d*t* is all the time the "Normal use / 100%".

In a system according to an exemplifying and non-limiting embodiment, the processing equipment 103 shown in figure 1 is configured to repeatedly estimate the stress *σ*(*t*) at the observation point 111 of the mechanical structure 109 based on data indicative of mechanical loading directed to the mechanical structure 109. The estimating rate can be e.g. in the range from 0.01 Hz to 20 Hz. In other words, a time interval between successive estimates of the stress *σ*(*t*) can be from 50 millisecond to 100 seconds. The measuring rate is advantageously significantly greater than the above-mentioned estimating rate. The measuring rate can be for example in the range from 1 Hz to 5 kHz. It is also possible that the system comprises a data interface for receiving, from an external device, data indicative of the stress *σ*(*t*) at the observation point 111 of the mechanical structure 109.

In a system according to an exemplifying and non-limiting embodiment, the processing equipment 103 is configured to compute the stress *σ*(*t*) at the observation point 111 as a weighted sum of i) membrane stress σₘ(*t*) and ii) bending stress σ_{b}(*t*) acting on an area of the mechanical structure 109 a distance away from the observation point 111 of the mechanical structure 109. The weight factors of the weighted sum are predetermined local stress concentration factors *K*_{t,m} and *K*_{t,b} defined separately for the membrane and bending stresses σₘ(*t*) and σ_{b}(*t*). Therefore, in this exemplifying case, the processing equipment 103 is configured to compute the following stress *σₖ*(*t*) according to the following equation: ${σ}_{k} \left(t\right) = {K}_{t , m} {σ}_{m} \left(t\right) + {K}_{t , b} {σ}_{b} \left(t\right) .$ (4)

An exemplifying way to determine the local stress concentration factors based on the finite element analysis "FEA" is presented in the publication A. Ahola, T. Nykänen and T. Björk: Effect of loading type on the fatigue strength of asymmetric and symmetric transverse non-load carrying attachments, School of Energy Systems, Lappeenranta University of Technology, Wiley Publishing Ltd. Fatigue Fract Engng Mater Struct, 2017, 40, pp. 670-682. An exemplifying way to determine the local stress concentration factors based on an artificial neutral network "ANN" is presented in the publication M. Dabiri, M. Ghafouri, H. R. Rohani Raftar, and T. Björk: Neural network-based assessment of the stress concentration factor in a T-welded joint, Laboratory of Steel Structures, Lappeenranta University of Technology, Journal of Constructional Steel Research 128, 2017, pp. 567-578. An exemplifying way to determine the local stress concentration factors based on analytical equations is presented in the publication K. lida and T. Uemura: Stress concentration factor formulae widely used in Japan, University of Tokyo, Fatigue Fract. Engng Mater. Struct. Vol. 19, No. 6, pp. 779-786, 1996.

In a system according to an exemplifying and non-limiting embodiment, the processing equipment 103 is configured to compute the above-mentioned membrane stress σₘ(*t*) and the bending stress σ_{b}(*t*) based on outputs *s*1(*t*) and *s*2(*t*) of strain gauges 104 and 105 attached to the mechanical structure 109. The membrane stress σₘ(*t*) proportional to an average (*s*1(*t*) + *s*2(*t*))/2 of the outputs of the strain gauges 104 and 105, and the bending stress σ_{b}(*t*) is proportional to a difference *s*1(*t*) - *s*2(*t*) of the outputs of the strain gauges 104 and 105. In many cases, there can be more than two strain gauges.

In a system according to an exemplifying and non-limiting embodiment, the processing equipment 103 is configured to compute the stress *σₖ*(*t*) at the observation point 111 of the mechanical structure 109 based on forces directed to the mechanical structure 109, an inverse of a stiffness matrix of a finite element model of at least a part of the mechanical structure 109, and element level force-displacement equations of the finite element model expressing the stress *σₖ*(*t*) as a function of nodal displacements of appropriate nodes of the finite element model. In an exemplifying case where the mechanical structure 109 operates in the linear area so that the Hooke's law is valid, the memory equipment 101 is advantageously configured to store the inverse of the stiffness matrix of the finite element model and the processing equipment 103 is advantageously configured to use the stored inverse of the stiffness matrix when repeatedly computing the stress *σₖ*(*t*). Thus, there is no need to compute the inverse of the stiffness matrix every time when the stress *σₖ*(*t*) is computed.

In a system according to an exemplifying and non-limiting embodiment, each of the response values *N*_{1,1}, ..., *N*_{P,Q} is associated, in addition to the predetermined stress range and the predetermined mean stress, with one or more quantities descriptive of operating conditions of the mechanical structure 109. The one or more quantities may comprise for example temperature of the mechanical structure 109 because the strength capacity of the mechanical structure 109 may depend on the temperature. In this exemplifying case, the processing equipment 103 is configured to update each stress history value *n*_{1,1}(*t*), ..., *n*_{P,Q}(*t*) to express number of cycles occurred in the time-trend of the stress so that 1) the occurred cycles have the predetermined stress range and the predetermined mean stress related to the response value under consideration and 2) the operating conditions of the mechanical structure 109 correspond to the one or more quantities related to the response value under consideration, e.g. the temperature of the mechanical structure belongs to a temperature range related to the response value under consideration and/or an effect of a corrosive environment on the material fatigue performance corresponds to a same effect of a corrosive environment related to the response value under consideration. In this exemplifying embodiment, one or more of the response values *N*_{1,1}, ..., *N*_{P,Q} can be related to a same stress range and a same mean stress, and the one or more quantities descriptive of the operating conditions make difference between these response values.

The implementation of the processing equipment 103 can be based on one or more analogue circuits, one or more digital processing circuits, or a combination thereof. Each digital processing circuit can be a programmable processor circuit provided with appropriate software, a dedicated hardware processor such as for example an application specific integrated circuit "ASIC", or a configurable hardware processor such as for example a field programmable gate array "FPGA". The memory equipment 101 may comprise one or more memory circuits each of which can be for example a Random-Access Memory "RAM" circuit.

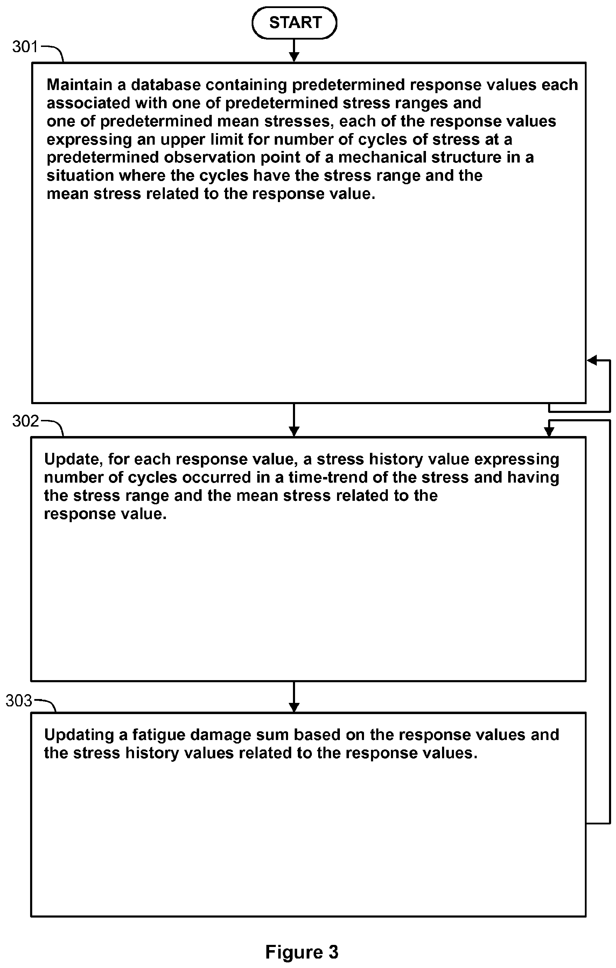

Figure 3 shows a flowchart of a method according to an exemplifying and non-limiting embodiment for monitoring fatigue of a mechanical structure. The method comprises the following actions:
- action 301: maintaining a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- action 302: repeatedly updating, for each of the response values, a stress history value expressing number of cycles occurred in a time-trend of the stress and having the predetermined stress range and the predetermined mean stress related to the response value under consideration, and
- action 303: repeatedly updating a fatigue damage sum based on the response values and the stress history values related to the response values, the fatigue damage sum expressing cumulated fatigue damage of the mechanical structure.

A method according to an exemplifying and non-limiting embodiment comprises repeatedly estimating the stress at the predetermined observation point of the mechanical structure based on data indicative of mechanical loading directed to the mechanical structure.

A method according to an exemplifying and non-limiting embodiment comprises computing the stress as a weighted sum of i) membrane stress and ii) bending stress acting on an area of the mechanical structure a distance away from the predetermined observation point of the mechanical structure. The weight factors of the weighted sum are predetermined local stress concentration factors defined separately for the membrane and bending stresses.

A method according to an exemplifying and non-limiting embodiment comprises computing the membrane stress and the bending stress based on outputs of strain gauges attached to the mechanical structure. The membrane stress is proportional to an average of the outputs of the strain gauges and the bending stress is proportional to a difference of the outputs of the strain gauges.

A method according to an exemplifying and non-limiting embodiment comprises computing the stress based on forces directed to the mechanical structure, an inverse of a stiffness matrix of a finite element model of at least a part of the mechanical structure, and element level force-displacement equations of the finite element model expressing the stress as a function of nodal displacements of the finite element model.

A method according to an exemplifying and non-limiting embodiment comprises storing the inverse of the stiffness matrix of the finite element model in memory equipment and using the stored inverse of the stiffness matrix when repeatedly computing the stress.

A method according to an exemplifying and non-limiting embodiment comprises computing the fatigue damage sum *D* according to the formula: $D = {\sum }_{i , j} \frac{{n}_{i , j} \left(t\right)}{{N}_{i , j}} ,$ where *n_{i,j}*(*t*) is the stress history value expressing the number of the cycles occurred in the time-trend of the stress and having the *i*^{th} predetermined stress range and the *j*^{th} predetermined mean stress, and *N_{i,j}* is the response value relating to the *i*^{th} predetermined stress range and to the *j*^{th} predetermined mean stress.

In a method according to an exemplifying and non-limiting embodiment, each of the response values is associated, in addition to the predetermined stress range and the predetermined mean stress, with one or more quantities descriptive of operating conditions of the mechanical structure e.g. temperature of the mechanical structure. In a method according to this exemplifying and non-limiting embodiment, each stress history value is updated to express number of cycles occurred in the time-trend of the stress so that 1) the occurred cycles have the predetermined stress range and the predetermined mean stress related to the response value under consideration and 2) the operating conditions of the mechanical structure correspond to the one or more quantities related to the response value under consideration.

A method according to an exemplifying and non-limiting embodiment comprises controlling a display element to show growth of the fatigue damage sum as a function of cumulative service produced by the mechanical structure.

A method according to an exemplifying and non-limiting embodiment comprises computing an average growth rate of the fatigue damage sum and estimating remaining service producible by the mechanical structure based on: i) a current value of the fatigue damage sum, ii) the average growth rate of the fatigue damage sum, and iii) a value of the fatigue damage sum corresponding to a predetermined damage probability.

A method according to an exemplifying and non-limiting embodiment comprises computing an estimate for an instantaneous growth rate of the fatigue damage sum and estimating remaining service producible by the mechanical structure based on: i) a current value of the fatigue damage sum, ii) the estimate of the instantaneous growth rate of the fatigue damage sum, and iii) a value of the fatigue damage sum corresponding to a predetermined damage probability.

A computer program according to an exemplifying and non-limiting embodiment comprises computer executable instructions for controlling programmable processing equipment to carry out actions related to a method according to any of the above-described exemplifying and non-limiting embodiments.

A computer program according to an exemplifying and non-limiting embodiment comprises software modules for monitoring fatigue of a mechanical structure. The software modules comprise computer executable instructions for controlling programmable processing equipment to:
- retrieve data from a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly update, for each of the response values, a stress history value expressing number of cycles occurred in a time-trend of the stress and having the predetermined stress range and the predetermined mean stress related to the response value under consideration, and
- repeatedly update a fatigue damage sum based on the response values and the stress history values related to the response values, the fatigue damage sum expressing cumulated fatigue damage of the mechanical structure.

The software modules can be for example subroutines or functions implemented with programming tools suitable for the programmable processing equipment.

A computer program product according to an exemplifying and non-limiting embodiment comprises a computer readable medium, e.g. a compact disc "CD", encoded with a computer program according to an exemplifying and non-limiting embodiment.

A signal according to an exemplifying and non-limiting embodiment is encoded to carry information defining a computer program according to an exemplifying and non-limiting embodiment.

The specific examples provided in the description given above should not be construed as limiting the scope and/or the applicability of the accompanied claims.

Lists and groups of examples provided in the description given above are not exhaustive unless otherwise explicitly stated.

## Claims

1. A system for monitoring fatigue of a mechanical structure, **characterized in that** the system comprises memory equipment (101) storing a database (102) containing predetermined response values (*N*_{1,1}, ..., *N*_{P,Q}) each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure, wherein the system comprises processing equipment (103) configured to:
- repeatedly update, for each of the response values, a corresponding stress history value (*n*_{1,1}(*t*), *..., n*_{P,Q}(*t*)) expressing number of cycles occurred in a time-trend of the stress and having the predetermined stress range and the predetermined mean stress related to the response value under consideration, and
- repeatedly update a fatigue damage sum (D) based on the response values and the stress history values related to the response values, the fatigue damage sum expressing cumulated fatigue damage of the mechanical structure
- repeatedly estimate the stress at the predetermined observation point of the mechanical structure based on data indicative of mechanical loading directed to the mechanical structure,
wherein the processing equipment is configured to compute the stress as a weighted sum of i) membrane stress (σₘ(*t*)) and ii) bending stress (σ_{b}(*t*)) acting on an area of the mechanical structure a distance away from the predetermined observation point of the mechanical structure, weight factors of the weighted sum being predetermined local stress concentration factors (*K*_{t,m}, *K*_{t,b}) defined separately for the membrane and bending stresses.

2. A system for monitoring fatigue of a mechanical structure, **characterized in that** the system comprises memory equipment (101) storing a database (102) containing predetermined response values (*N*_{1,1}, ..., *N*_{P,Q}) each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure, wherein the system comprises processing equipment (103) configured to:
- repeatedly update, for each of the response values, a corresponding stress history value (*n*_{1,1}(*t*), ..., *n*_{P,Q}(*t*)) expressing number of cycles occurred in a time-trend of the stress and having the predetermined stress range and the predetermined mean stress related to the response value under consideration, and
- repeatedly update a fatigue damage sum (*D*) based on the response values and the stress history values related to the response values, the fatigue damage sum expressing cumulated fatigue damage of the mechanical structure,
wherein:
- each of the response values is associated, in addition to the predetermined stress range and the predetermined mean stress, with one or more quantities descriptive of operating conditions of the mechanical structure, and
- the processing equipment is configured to update each stress history value to express number of cycles occurred in the time-trend of the stress so that the occurred cycles have the predetermined stress range and the predetermined mean stress related to the response value under consideration and the operating conditions of the mechanical structure correspond to the one or more quantities related to the response value under consideration.

3. A system for monitoring fatigue of a mechanical structure, **characterized in that** the system comprises memory equipment (101) storing a database (102) containing predetermined response values (*N*_{1,1}, ..., *N*_{P,Q}) each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure, wherein the system comprises processing equipment (103) configured to:
- repeatedly update, for each of the response values, a corresponding stress history value (*n*_{1,1}(*t*), ..., *n*_{P,Q}(*t*)) expressing number of cycles occurred in a time-trend of the stress and having the predetermined stress range and the predetermined mean stress related to the response value under consideration, and
- repeatedly update a fatigue damage sum (*D*) based on the response values and the stress history values related to the response values, the fatigue damage sum expressing cumulated fatigue damage of the mechanical structure,
wherein each of the response values *N_{k,q},* where *k =* 1, 2, ..., P and *q =* 1, 2, ..., Q is: ${N}_{k , q} = \frac{{C}_{ref}}{{\left(\frac{Δ {σ}_{q}}{\sqrt{1 - {R}_{local}}}\right)}^{{m}_{ref}}} ,$
where *C_{ref}* is a fatigue performance specific to the mechanical structure and corresponds to the predetermined survival probability, Δ*σ_{q}* is the predetermined stress range at the predetermined observation point of the mechanical structure and related to the response value *N_{k,q},* and *m_{ref}* is a model parameter being a slope of a S-N curve, and *R_{local}* is a local stress ratio at the predetermined observation point of the mechanical structure: ${R}_{local} = \frac{{σ}_{mean} - Δ σ / 2}{{σ}_{mean} + Δ σ / 2} ,$
where *σₘₑₐₙ* and Δ*σ* are a mean stress and a stress range at the observation point of the mechanical structure.

4. A system according to claim 1, wherein the processing equipment is configured to compute the membrane stress and the bending stress based on outputs (s1(*f*), s2(t)) of strain gauges attached to the mechanical structure, the membrane stress being proportional to an average of the outputs of the strain gauges and the bending stress being proportional to a difference of the outputs of the strain gauges.

5. A system according to claim 4, wherein the system comprises the strain gauges (104, 105).

6. A system according to any of claims 1-5, wherein the processing equipment is configured to compute the fatigue damage sum *D* according to the formula: $D = {\sum }_{i , j} \frac{{n}_{i , j} \left(t\right)}{{N}_{i , j}} ,$ where *n_{i,j}*(*t*) is the stress history value expressing the number of the cycles occurred in the time-trend of the stress and having the *i*^{th} predetermined stress range and the *j*^{th} predetermined mean stress, and *N_{i,j}* is the response value relating to the *i*^{th} predetermined stress range and to the *j*^{th} predetermined mean stress.

7. A system according claim 2, wherein the one or more quantities descriptive of the operating conditions of the mechanical structure comprise temperature of the mechanical structure.

8. A system according to any one of claims 1-7, wherein the system comprises a display element (106) and the processing equipment is configured to control the display element to show growth of the fatigue damage sum as a function of cumulative service produced by the mechanical structure.

9. A system according to any one of claims 1-8, wherein the processing equipment is configured to compute an average growth rate (223) of the fatigue damage sum and to estimate remaining service (*P*ᵣₑₛ1,1) producible by the mechanical structure based on: i) a current value (*D*_{curr}) of the fatigue damage sum, ii) the average growth rate of the fatigue damage sum, and iii) a value of the fatigue damage sum corresponding to a predetermined damage probability.

10. A system according to any one of claims 1-9, wherein the processing equipment is configured to compute an estimate for an instantaneous growth rate (224) of the fatigue damage sum and to estimate remaining service (*P*ᵣₑₛ1,2) producible by the mechanical structure based on: i) a current value (*D*_{curr}) of the fatigue damage sum, ii) the estimate of the instantaneous growth rate of the fatigue damage sum, and iii) a value of the fatigue damage sum corresponding to a predetermined damage probability.

11. A method for monitoring fatigue of a mechanical structure, **characterized in that** the method comprises:
- maintaining (301) a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly updating (302), for each of the response values, a corresponding stress history value expressing number of cycles occurred in a time-trend of the stress and having the predetermined stress range and the predetermined mean stress related to the response value under consideration, and
- repeatedly updating (303) a fatigue damage sum based on the response values and the stress history values related to the response values, the fatigue damage sum expressing cumulated fatigue damage of the mechanical structure
- repeatedly estimating the stress at the predetermined observation point of the mechanical structure based on data indicative of mechanical loading directed to the mechanical structure,
wherein the stress is computed as a weighted sum of i) membrane stress (σₘ(*t*)) and ii) bending stress (σ_{b}(*t*)) acting on an area of the mechanical structure a distance away from the predetermined observation point of the mechanical structure, weight factors of the weighted sum being predetermined local stress concentration factors (*K*_{t,m}, *K*_{t,b}) defined separately for the membrane and bending stresses.

12. A method for monitoring fatigue of a mechanical structure, **characterized in that** the method comprises:
- maintaining (301) a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly updating (302), for each of the response values, a corresponding stress history value expressing number of cycles occurred in a time-trend of the stress and having the predetermined stress range and the predetermined mean stress related to the response value under consideration, and
- repeatedly updating (303) a fatigue damage sum based on the response values and the stress history values related to the response values, the fatigue damage sum expressing cumulated fatigue damage of the mechanical structure,
wherein:
- each of the response values is associated, in addition to the predetermined stress range and the predetermined mean stress, with one or more quantities descriptive of operating conditions of the mechanical structure, and
- each stress history value is updated to express number of cycles occurred in the time-trend of the stress so that the occurred cycles have the predetermined stress range and the predetermined mean stress related to the response value under consideration and the operating conditions of the mechanical structure correspond to the one or more quantities related to the response value under consideration.

13. A method for monitoring fatigue of a mechanical structure, **characterized in that** the method comprises:
- maintaining (301) a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly updating (302), for each of the response values, a corresponding stress history value expressing number of cycles occurred in a time-trend of the stress and having the predetermined stress range and the predetermined mean stress related to the response value under consideration, and
- repeatedly updating (303) a fatigue damage sum based on the response values and the stress history values related to the response values, the fatigue damage sum expressing cumulated fatigue damage of the mechanical structure,
wherein each of the response values *N_{k,q},* where *k =* 1, 2, ..., P and *q =* 1, 2, ..., Q is: ${N}_{k , q} = \frac{{C}_{ref}}{{\left(\frac{Δ {σ}_{q}}{\sqrt{1 - {R}_{local}}}\right)}^{{m}_{ref}}} ,$
where *C_{ref}* is a fatigue performance specific to the mechanical structure and corresponds to the predetermined survival probability, Δ*σ_{q}* is the predetermined stress range at the predetermined observation point of the mechanical structure and related to the response value *N_{k,q},* and *m_{ref}* is a model parameter being a slope of a S-N curve, and *R_{local}* is a local stress ratio at the predetermined observation point of the mechanical structure: ${R}_{local} = \frac{{σ}_{mean} - Δ σ / 2}{{σ}_{mean} + Δ σ / 2} ,$
where *σₘₑₐₙ* and Δ*σ* are a mean stress and a stress range at the observation point of the mechanical structure.

14. A computer program for monitoring fatigue of a mechanical structure, **characterized in that** the computer program comprises computer executable instructions for controlling programmable processing equipment to:
- retrieve data from a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly update, for each of the response values, a corresponding stress history value expressing number of cycles occurred in a time-trend of the stress and having the predetermined stress range and the predetermined mean stress related to the response value under consideration, and
- repeatedly update a fatigue damage sum based on the response values and the stress history values related to the response values, the fatigue damage sum expressing cumulated fatigue damage of the mechanical structure,
- repeatedly estimate the stress at the predetermined observation point of the mechanical structure based on data indicative of mechanical loading directed to the mechanical structure,
wherein the computer program comprises computer executable instructions for controlling the programmable processing equipment to compute the stress as a weighted sum of i) membrane stress (σₘ(*t*)) and ii) bending stress (σ_{b}(*t*)) acting on an area of the mechanical structure a distance away from the predetermined observation point of the mechanical structure, weight factors of the weighted sum being predetermined local stress concentration factors (*K*_{t,m}, *K*_{t,b}) defined separately for the membrane and bending stresses.

15. A computer program for monitoring fatigue of a mechanical structure, **characterized in that** the computer program comprises computer executable instructions for controlling programmable processing equipment to:
- retrieve data from a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly update, for each of the response values, a corresponding stress history value expressing number of cycles occurred in a time-trend of the stress and having the predetermined stress range and the predetermined mean stress related to the response value under consideration, and
- repeatedly update a fatigue damage sum based on the response values and the stress history values related to the response values, the fatigue damage sum expressing cumulated fatigue damage of the mechanical structure,
wherein:
- each of the response values is associated, in addition to the predetermined stress range and the predetermined mean stress, with one or more quantities descriptive of operating conditions of the mechanical structure, and
- the computer program comprises computer executable instructions for controlling the programmable processing equipment to update each stress history value to express number of cycles occurred in the time-trend of the stress so that the occurred cycles have the predetermined stress range and the predetermined mean stress related to the response value under consideration and the operating conditions of the mechanical structure correspond to the one or more quantities related to the response value under consideration.

16. A computer program for monitoring fatigue of a mechanical structure, **characterized in that** the computer program comprises computer executable instructions for controlling programmable processing equipment to:
- retrieve data from a database containing predetermined response values each being associated with one of predetermined stress ranges and one of predetermined mean stresses, each of the response values expressing an upper limit for number of cycles of stress at a predetermined observation point of the mechanical structure in a situation in which the cycles have the predetermined stress range and the predetermined mean stress related to the response value under consideration, the upper limit corresponding to a predetermined survival probability of the mechanical structure,
- repeatedly update, for each of the response values, a corresponding stress history value expressing number of cycles occurred in a time-trend of the stress and having the predetermined stress range and the predetermined mean stress related to the response value under consideration, and
- repeatedly update a fatigue damage sum based on the response values and the stress history values related to the response values, the fatigue damage sum expressing cumulated fatigue damage of the mechanical structure,
wherein each of the response values *N_{k,q},* where *k =* 1, 2, ..., P and *q =* 1, 2, ..., Q is: ${N}_{k , q} = \frac{{C}_{ref}}{{\left(\frac{Δ {σ}_{q}}{\sqrt{1 - {R}_{local}}}\right)}^{{m}_{ref}}} ,$
where *C_{ref}* is a fatigue performance specific to the mechanical structure and corresponds to the predetermined survival probability, Δ*σ_{q}* is the predetermined stress range at the predetermined observation point of the mechanical structure and related to the response value *N_{k,q},* and *m_{ref}* is a model parameter being a slope of a S-N curve, and *R_{local}* is a local stress ratio at the predetermined observation point of the mechanical structure: ${R}_{local} = \frac{{σ}_{mean} - Δ σ / 2}{{σ}_{mean} + Δ σ / 2} ,$
where *σₘₑₐₙ* and Δ*σ* are a mean stress and a stress range at the observation point of the mechanical structure.

## Patentansprüche

1. System zur Überwachung der Ermüdung einer mechanischen Struktur, **dadurch gekennzeichnet, dass** das System eine Speicherausstattung (101) umfasst, die eine Datenbank (102) speichert, die vorbestimmte Antwortwerte (*N*_{1,1}, ..., *N*_{P,Q}) enthält, die jeweils einem von vorbestimmten Spannungsbereichen und einem von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht, wobei das System eine Verarbeitungsausstattung (103) umfasst, die ausgebildet ist zum:
- wiederholten Aktualisieren, für jeden der Antwortwerte, eines entsprechenden Spannungsverlaufswerts (*n*_{1,1}(*t*),*...,n*_{P,Q}(*t*)), der eine Anzahl von Zyklen ausdrückt, die in einem Zeittrend der Spannung aufgetreten sind, und der den vorbestimmten Spannungsbereich und die vorbestimmte mittlere Spannung in Bezug auf den betrachteten Antwortwert aufweist, und
- wiederholten Aktualisieren einer Ermüdungsschadenssumme (*D*) basierend auf den Antwortwerten und den Spannungsverlaufswerten in Bezug auf die Antwortwerte, wobei die Ermüdungsschadenssumme einen kumulierten Ermüdungsschaden der mechanischen Struktur ausdrückt,
- wiederholten Schätzen der Spannung an dem vorbestimmten Beobachtungspunkt der mechanischen Struktur basierend auf Daten, die auf die auf die mechanische Struktur gerichtete mechanische Belastung hinweisen,
wobei die Verarbeitungsausstattung dazu ausgebildet ist, die Spannung als gewichtete Summe einer i) Membranspannung (*σₘ*(*t*)) und ii) einer Biegespannung (*σ_{b}*(*t*)) zu berechnen, die auf eine Fläche der mechanischen Struktur wirken, die sich in einem Abstand von dem vorbestimmten Beobachtungspunkt der mechanischen Struktur befindet, wobei die Gewichtsfaktoren der gewichteten Summe vorbestimmte lokale Spannungskonzentrationsfaktoren (*K*_{t,m}, *K*_{t,b}) sind, die für die Membran- und Biegespannungen separat definiert sind.

2. System zur Überwachung der Ermüdung einer mechanischen Struktur, **dadurch gekennzeichnet, dass** das System eine Speicherausstattung (101) umfasst, die eine Datenbank (102) speichert, die vorbestimmte Antwortwerte (*N*_{1,1}, ..., *N*_{P,Q}) enthält, die jeweils einem von vorbestimmten Spannungsbereichen und einem von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht, wobei das System eine Verarbeitungsausstattung (103) umfasst, die ausgebildet ist zum:
- wiederholten Aktualisieren, für jeden der Antwortwerte, eines entsprechenden Spannungsverlaufswerts **(*n*_{1,1}(*t*),...,*n*_{P,Q}(*t*)),** der eine Anzahl von Zyklen ausdrückt, die in einem Zeittrend der Spannung aufgetreten sind, und der den vorbestimmten Spannungsbereich und die vorbestimmte mittlere Spannung in Bezug auf den betrachteten Antwortwert aufweist, und
- wiederholten Aktualisieren einer Ermüdungsschadenssumme (*D*) basierend auf den Antwortwerten und den Spannungsverlaufswerten in Bezug auf die Antwortwerte, wobei die Ermüdungsschadenssumme einen kumulierten Ermüdungsschaden der mechanischen Struktur ausdrückt,
wobei
- jedem der Antwortwerte zusätzlich zu dem vorbestimmten Spannungsbereich und der vorbestimmten mittleren Spannung eine oder mehrere Größen zugeordnet sind, die die Betriebsbedingungen der mechanischen Struktur beschreiben, und
- die Verarbeitungsausstattung dazu ausgebildet ist, jeden Spannungsverlaufswert zu aktualisieren, um die Anzahl der in dem Zeittrend der Spannung aufgetretenen Zyklen auszudrücken, so dass die aufgetretenen Zyklen den vorbestimmten Spannungsbereich und die vorbestimmte mittlere Spannung in Bezug auf den betrachteten Antwortwert haben und die Betriebsbedingungen der mechanischen Struktur einer oder mehreren Größen entsprechen, die sich auf den betrachteten Antwortwert beziehen.

3. System zur Überwachung der Ermüdung einer mechanischen Struktur, **dadurch gekennzeichnet, dass** das System eine Speicherausstattung (101) umfasst, die eine Datenbank (102) speichert, die vorbestimmte Antwortwerte (*N*_{1,1}, ..., *N*_{P,Q}) enthält, die jeweils einem von vorbestimmten Spannungsbereichen und einem von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht, wobei das System eine Verarbeitungsausstattung (103) umfasst, die ausgebildet ist zum:
- wiederholten Aktualisieren, für jeden der Antwortwerte, eines entsprechenden Spannungsverlaufswerts **(*n*_{1,1}(*t*),...,*n*_{P*,*Q}(*t*))*,*** der eine Anzahl von Zyklen ausdrückt, die in einem Zeittrend der Spannung aufgetreten sind, und der den vorbestimmten Spannungsbereich und die vorbestimmte mittlere Spannung in Bezug auf den betrachteten Antwortwert aufweist, und
- wiederholten Aktualisieren einer Ermüdungsschadenssumme (*D*) basierend auf den Antwortwerten und den Spannungsverlaufswerten in Bezug auf die Antwortwerte, wobei die Ermüdungsschadenssumme einen kumulierten Ermüdungsschaden der mechanischen Struktur ausdrückt,
wobei jeder der Antwortwerte *N_{k,q}* für *k* = 1, 2, ..., P und *q* = 1, 2, ..., Q wie folgt gegeben ist: ${N}_{k , q} = \frac{{C}_{ref}}{{\left(\frac{Δ {σ}_{q}}{\sqrt{1 - {R}_{local}}}\right)}^{{m}_{ref}}} ,$
wobei *C_{ref}* eine für die mechanische Struktur spezifische Ermüdungsleistung ist und der vorbestimmten Überlebenswahrscheinlichkeit entspricht, Δ*σ_{q}* der vorbestimmte Spannungsbereich an dem vorbestimmten Beobachtungspunkt der mechanischen Struktur ist und sich auf den Antwortwert *N_{k,q}* bezieht, und *m*_{ref} ein Modellparameter ist, der eine Steigung einer S-N-Kurve darstellt, und *R*_{local} ein lokales Spannungsverhältnis an dem vorbestimmten Beobachtungspunkt der mechanischen Struktur ist: ${R}_{local} = \frac{{σ}_{mean} - Δ σ / 2}{{σ}_{mean} + Δ σ / 2} ,$
wobei σₘₑₐₙ eine mittlere Spannung und Δ*σ* ein Spannungsbereich an dem Beobachtungspunkt der mechanischen Struktur sind.

4. System nach Anspruch 1, wobei die Verarbeitungsausstattung dazu ausgebildet ist, die Membranspannung und die Biegespannung basierend auf den Ausgaben (*s*1(*t*), *s*2(*t*)) von an der mechanischen Struktur angebrachten Dehnungsmessern zu berechnen, wobei die Membranspannung proportional zu einem Durchschnitt der Ausgaben der Dehnungsmesser ist und die Biegespannung proportional zu einer Differenz der Ausgaben der Dehnungsmesser ist.

5. System nach Anspruch 4, wobei das System die Dehnungsmesser (104, 105) umfasst.

6. System nach einem der Ansprüche 1-5, wobei die Verarbeitungsausstattung dazu ausgebildet ist, die Ermüdungsschadenssumme *D* gemäß der folgenden Formel zu berechnen: $D = {\sum }_{i , j} \frac{{n}_{i , j} \left(t\right)}{{N}_{i , j}} ,$ wobei ***n_{i,j}*(*t*)** der Spannungsverlaufswert ist, der die Anzahl der im Zeittrend der Spannung aufgetretenen Zyklen ausdrückt und den i-ten vorbestimmten Spannungsbereich und die j-te vorbestimmte mittlere Spannung aufweist, und ***N_{i,j}*** der Antwortwert ist, der sich auf *den* i-ten vorbestimmten Spannungsbereich und die j-te vorbestimmte mittlere Spannung bezieht.

7. System nach Anspruch 2, wobei die eine oder die mehreren Größen, die die Betriebsbedingungen der mechanischen Struktur beschreiben, die Temperatur der mechanischen Struktur umfassen.

8. System nach einem der Ansprüche 1-7, wobei das System ein Anzeigeelement (106) umfasst und die Verarbeitungsausstattung dazu ausgebildet ist, das Anzeigeelement zu steuern, um das Anwachsen der Ermüdungsschadenssumme als Funktion der kumulierten durch die mechanische Struktur erbrachten Betriebsleistung anzuzeigen.

9. System nach einem der Ansprüche 1-8, wobei die Verarbeitungsausstattung dazu ausgebildet ist, eine durchschnittliche Wachstumsrate (223) der Ermüdungsschadenssumme zu berechnen und die durch die mechanische Struktur erzeugbare verbleibende Betriebsleistung (***P***ᵣₑₛ **1,1)** zu abschätzen, basierend auf: i) einem aktuellen Wert (***D***_{curr}) der Ermüdungsschadenssumme, ii) der durchschnittlichen Wachstumsrate der Ermüdungsschadenssumme, und iii) einem Wert der Ermüdungsschadenssumme, der einer vorbestimmten Schadenswahrscheinlichkeit entspricht.

10. System nach einem der Ansprüche 1-9, wobei die Verarbeitungsausstattung dazu ausgebildet ist, eine Schätzung für eine momentane Wachstumsrate (224) der Ermüdungsschadenssumme zu berechnen und eine durch die mechanische Struktur erzeugbare verbleibende Betriebsleistung **(*P*ᵣₑₛ 1,2**) abzuschätzen, basierend auf: i) einem aktuellen Wert (***D***_{curr}) der Ermüdungsschadenssumme, ii) der Schätzung der momentanen Wachstumsrate der Ermüdungsschadenssumme, und iii) einem Wert der Ermüdungsschadenssumme, der einer vorbestimmten Schadenswahrscheinlichkeit entspricht.

11. Verfahren zur Überwachung der Ermüdung einer mechanischen Struktur, **dadurch gekennzeichnet, dass** das Verfahren umfasst:
- Pflegen (301) einer Datenbank mit vorbestimmten Antwortwerten, die jeweils einem von vorbestimmten Spannungsbereichen und einer von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht,
- wiederholtes Aktualisieren (302), für jeden der Antwortwerte, eines entsprechenden Spannungsverlaufswerts, der eine Anzahl der Zyklen ausdrückt, die in einem Zeittrend der Spannung aufgetreten sind und den vorbestimmten Spannungsbereich und die vorbestimmte mittlere Spannung in Bezug auf den betrachteten Antwortwert aufweisen, und
- wiederholtes Aktualisieren (303) einer Ermüdungsschadenssumme basierend auf den Antwortwerten und den Spannungsverlaufswerten in Bezug auf die Antwortwerte, wobei die Ermüdungsschadenssumme den kumulierten Ermüdungsschaden der mechanischen Struktur ausdrückt,
- wiederholtes Schätzen der Spannung an dem vorbestimmten Beobachtungspunkt der mechanischen Struktur basierend auf Daten, die auf die auf die mechanische Struktur gerichtete mechanische Belastung hinweisen,
wobei die Spannung als gewichtete Summe einer i) Membranspannung (***σₘ***(***t***)) und ii) einer Biegespannung (***σ_{b}***(***t***)) zu berechnen, die auf eine Fläche der mechanische Struktur wirken, die sich in einem Abstand von dem vorbestimmten Beobachtungspunkt der mechanischen Struktur befindet, wobei die Gewichtsfaktoren der gewichteten Summe vorbestimmte lokale Spannungskonzentrationsfaktoren (***K***_{**t,**m}, ***K*_{t,b}**) sind, die für die Membran- und Biegespannungen separat definiert sind.

12. Verfahren zur Überwachung der Ermüdung einer mechanischen Struktur, **dadurch gekennzeichnet, dass** das Verfahren umfasst:
- Pflegen (301) einer Datenbank mit vorbestimmten Antwortwerten, die jeweils einem von vorbestimmten Spannungsbereichen und einer von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht,
- wiederholtes Aktualisieren (302), für jeden der Antwortwerte, eines entsprechenden Spannungsverlaufswerts, der eine Anzahl der Zyklen ausdrückt, die in einem Zeittrend der Spannung aufgetreten sind und den vorbestimmten Spannungsbereich und die vorbestimmte mittlere Spannung in Bezug auf den betrachteten Antwortwert aufweisen, und
- wiederholtes Aktualisieren (303) einer Ermüdungsschadenssumme basierend auf den Antwortwerten und den Spannungsverlaufswerten in Bezug auf die Antwortwerte, wobei die Ermüdungsschadenssumme den kumulierten Ermüdungsschaden der mechanischen Struktur ausdrückt,
wobei
- jedem der Antwortwerte zusätzlich zu dem vorbestimmten Spannungsbereich und der vorbestimmten mittleren Spannung eine oder mehrere Größen zugeordnet sind, die die Betriebsbedingungen der mechanischen Struktur beschreiben, und
- jeder Spannungsverlaufswert aktualisiert wird, um die Anzahl der in dem Zeittrend der Spannung aufgetretenen Zyklen auszudrücken, so dass die aufgetretenen Zyklen den vorbestimmten Spannungsbereich und die vorbestimmte mittlere Spannung in Bezug auf den betrachteten Antwortwert haben und die Betriebsbedingungen der mechanischen Struktur einer oder mehreren Größen entsprechen, die sich auf den betrachteten Antwortwert beziehen.

13. Verfahren zur Überwachung der Ermüdung einer mechanischen Struktur, **dadurch gekennzeichnet, dass** das Verfahren umfasst:
- Pflegen (301) einer Datenbank mit vorbestimmten Antwortwerten, die jeweils einem von vorbestimmten Spannungsbereichen und einer von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht,
- wiederholtes Aktualisieren (302), für jeden der Antwortwerte, eines entsprechenden Spannungsverlaufswerts, der eine Anzahl der Zyklen ausdrückt, die in einem Zeittrend der Spannung aufgetreten sind und den vorbestimmten Spannungsbereich und die vorbestimmte mittlere Spannung in Bezug auf den betrachteten Antwortwert aufweisen, und
- wiederholtes Aktualisieren (303) einer Ermüdungsschadenssumme basierend auf den Antwortwerten und den Spannungsverlaufswerten in Bezug auf die Antwortwerte, wobei die Ermüdungsschadenssumme den kumulierten Ermüdungsschaden der mechanischen Struktur ausdrückt,
wobei jeder der Antwortwerte ***N_{k,q}*** für *k* = 1, 2, ..., P und q = 1, 2, ..., Q wie folgt gegeben ist: ${N}_{k , q} = \frac{{C}_{ref}}{{\left(\frac{Δ {σ}_{q}}{\sqrt{1 - {R}_{local}}}\right)}^{{m}_{ref}}} ,$
wobei *C_{ref}* eine für die mechanische Struktur spezifische Ermüdungsleistung ist und der vorbestimmten Überlebenswahrscheinlichkeit entspricht, **Δ*σ_{q}*** der vorbestimmte Spannungsbereich an dem vorbestimmten Beobachtungspunkt der mechanischen Struktur ist und sich auf den Antwortwert ***N_{k,q}*** bezieht, und ***m***_{ref} ein Modellparameter ist, der eine Steigung einer S-N-Kurve darstellt, und ***R***_{local} ein lokales Spannungsverhältnis an dem vorbestimmten Beobachtungspunkt der mechanischen Struktur ist: ${R}_{local} = \frac{{σ}_{mean} - Δ σ / 2}{{σ}_{mean} + Δ σ / 2} ,$
wobei **σ**ₘₑₐₙ eine mittlere Spannung und **Δ*σ*** ein Spannungsbereich an dem Beobachtungspunkt der mechanischen Struktur sind.

14. Computerprogramm zur Überwachung der Ermüdung einer mechanischen Struktur, **dadurch gekennzeichnet, dass** das Computerprogramm computerausführbare Anweisungen zur Steuerung einer programmierbaren Verarbeitungsausstattung umfasst, zum:
- Abrufen von Daten aus einer Datenbank, die vorbestimmte Antwortwerte enthält, die jeweils einem von vorbestimmten Spannungsbereichen und einer von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht,
- wiederholten Aktualisieren, für jeden der Antwortwerte, eines entsprechenden Spannungsverlaufswerts, der eine Anzahl der in einem Zeittrend der Spannung aufgetretenen Zyklen ausdrückt und den vorbestimmten Spannungsbereich und die vorbestimmte mittlere Spannung in Bezug auf den betrachteten Antwortwert aufweist, und
- wiederholten Aktualisieren einer Ermüdungsschadenssumme basierend auf den Antwortwerten und den Spannungsverlaufswerten in Bezug auf die Antwortwerte, wobei die Ermüdungsschadenssumme den kumulierten Ermüdungsschaden der mechanischen Struktur ausdrückt,
- wiederholten Schätzen der Spannung an dem vorbestimmten Beobachtungspunkt der mechanischen Struktur basierend auf Daten, die auf die auf die mechanische Struktur gerichtete mechanische Belastung hinweisen,
wobei das Computerprogramm computerausführbare Anweisungen zur Steuerung der programmierbaren Verarbeitungsausstattung umfasst, um die Spannung als gewichtete Summe einer i) Membranspannung (***σₘ*(*t***)) und ii) einer Biegespannung (***σ_{b}***(***t***)) zu berechnen, die auf eine Fläche der mechanische Struktur wirken, die sich in einem Abstand von dem vorbestimmten Beobachtungspunkt der mechanischen Struktur befindet, wobei die Gewichtsfaktoren der gewichteten Summe vorbestimmte lokale Spannungskonzentrationsfaktoren (***K*_{t,m}, *K*_{t,b}**) sind, die für die Membran- und Biegespannungen separat definiert sind.

15. Computerprogramm zur Überwachung der Ermüdung einer mechanischen Struktur, **dadurch gekennzeichnet, dass** das Computerprogramm computerausführbare Anweisungen zur Steuerung einer programmierbaren Verarbeitungsausstattung umfasst, zum:
- Abrufen von Daten aus einer Datenbank, die vorbestimmte Antwortwerte enthält, die jeweils einem von vorbestimmten Spannungsbereichen und einer von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht,
- wiederholten Aktualisieren, für jeden der Antwortwerte, eines entsprechenden Spannungsverlaufswerts, der eine Anzahl der in einem Zeittrend der Spannung aufgetretenen Zyklen ausdrückt und den vorbestimmten Spannungsbereich und die vorbestimmte mittlere Spannung in Bezug auf den betrachteten Antwortwert aufweist, und
- wiederholten Aktualisieren einer Ermüdungsschadenssumme basierend auf den Antwortwerten und den Spannungsverlaufswerten in Bezug auf die Antwortwerte, wobei die Ermüdungsschadenssumme den kumulierten Ermüdungsschaden der mechanischen Struktur ausdrückt,
wobei
- jedem der Antwortwerte zusätzlich zu dem vorbestimmten Spannungsbereich und der vorbestimmten mittleren Spannung eine oder mehrere Größen zugeordnet sind, die die Betriebsbedingungen der mechanischen Struktur beschreiben, und
- das Computerprogramm computerausführbare Anweisungen zur Steuerung der programmierbaren Verarbeitungsausstattung umfasst, um jeden Spannungsverlaufswert zu aktualisieren, um die Anzahl der in dem Zeittrend der Spannung aufgetretenen Zyklen auszudrücken, so dass die aufgetretenen Zyklen den vorbestimmten Spannungsbereich und die vorbestimmte mittlere Spannung in Bezug auf den betrachteten Antwortwert haben und die Betriebsbedingungen der mechanischen Struktur einer oder mehreren Größen entsprechen, die sich auf den betrachteten Antwortwert beziehen.

16. Computerprogramm zur Überwachung der Ermüdung einer mechanischen Struktur, **dadurch gekennzeichnet, dass** das Computerprogramm computerausführbare Anweisungen zur Steuerung einer programmierbaren Verarbeitungsausstattung umfasst, zum:
- Abrufen von Daten aus einer Datenbank, die vorbestimmte Antwortwerte enthält, die jeweils einem von vorbestimmten Spannungsbereichen und einer von vorbestimmten mittleren Spannungen zugeordnet sind, wobei jeder der Antwortwerte eine Obergrenze für eine Anzahl von Spannungszyklen an einem vorbestimmten Beobachtungspunkt der mechanischen Struktur in einer Situation ausdrückt, in der die Zyklen den vorbestimmten Spannungsbereich und die vorbestimmte mittlere Spannung in Bezug auf den betrachteten Antwortwert aufweisen, wobei die Obergrenze einer vorbestimmten Überlebenswahrscheinlichkeit der mechanischen Struktur entspricht,
- wiederholten Aktualisieren, für jeden der Antwortwerte, eines entsprechenden Spannungsverlaufswerts, der eine Anzahl der in einem Zeittrend der Spannung aufgetretenen Zyklen ausdrückt und den vorbestimmten Spannungsbereich und die vorbestimmte mittlere Spannung in Bezug auf den betrachteten Antwortwert aufweist, und
- wiederholten Aktualisieren einer Ermüdungsschadenssumme basierend auf den Antwortwerten und den Spannungsverlaufswerten in Bezug auf die Antwortwerte, wobei die Ermüdungsschadenssumme den kumulierten Ermüdungsschaden der mechanischen Struktur ausdrückt,
wobei jeder der Antwortwerte *N_{k,q}* für *k* = 1, 2, ..., P und *q* = 1, 2, ..., Q wie folgt gegeben ist: ${N}_{k , q} = \frac{{C}_{ref}}{{\left(\frac{Δ {σ}_{q}}{\sqrt{1 - {R}_{local}}}\right)}^{{m}_{ref}}} ,$
wobei *C_{ref}* eine für die mechanische Struktur spezifische Ermüdungsleistung ist und der vorbestimmten Überlebenswahrscheinlichkeit entspricht, Δ*σ_{q}* der vorbestimmte Spannungsbereich an dem vorbestimmten Beobachtungspunkt der mechanischen Struktur ist und sich auf den Antwortwert *N_{k,q}* bezieht, und *m*_{ref} ein Modellparameter ist, der eine Steigung einer S-N-Kurve darstellt, und *R*_{local} ein lokales Spannungsverhältnis an dem vorbestimmten Beobachtungspunkt der mechanischen Struktur ist: ${R}_{local} = \frac{{σ}_{mean} - Δ σ / 2}{{σ}_{mean} + Δ σ / 2} ,$
wobei σₘₑₐₙ eine mittlere Spannung und **Δ*σ*** ein Spannungsbereich an dem Beobachtungspunkt der mechanischen Struktur sind.

## Revendications

1. Système de surveillance de la fatigue d'une structure mécanique, **caractérisé en ce que** le système comprend un équipement de mémoire (101) stockant une base de données (102) contenant des valeurs de réponse prédéterminées (*N*_{1,1}, ..., *N*_{P,Q}), chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique, dans lequel le système comprend un équipement de traitement (103) configuré pour :
- mettre à jour de manière répétée, pour chacune des valeurs de réponse, une valeur d'historique de contrainte correspondante (*n*_{1,1}(*t*), ..., *n*_{P,Q}(t)) exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée, une somme d'endommagement par fatigue (D) basée sur les valeurs de réponse et les valeurs d'historique de contrainte liées aux valeurs de réponse, la somme d'endommagement par fatigue exprimant l'endommagement par fatigue cumulé de la structure mécanique
- estimer de manière répétée la contrainte au point d'observation prédéterminé de la structure mécanique en se basant sur des données indiquant la charge mécanique dirigée vers la structure mécanique
dans lequel l'équipement de traitement est configuré pour calculer la contrainte en tant qu'une somme pondérée de i) contrainte de membrane (σₘ(ₜ)) et ii) contrainte de flexion (σ_{b}(ₜ)) agissant sur une zone de la structure mécanique à distance du point d'observation prédéterminé de la structure mécanique, des facteurs de poids de la somme pondérée étant des facteurs de concentration de contrainte locale prédéterminés (*K*_{t,m}, *K*_{t,b}) définis séparément pour les contraintes de membrane et de flexion.

2. Système de surveillance de la fatigue d'une structure mécanique, **caractérisé en ce que** le système comprend un équipement de mémoire (101) stockant une base de données (102) contenant des valeurs de réponse prédéterminées (*N*_{1,1}, ..., *N*_{P,Q}), chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique, dans lequel le système comprend un équipement de traitement (103) configuré pour :
- mettre à jour de manière répétée, pour chacune des valeurs de réponse, une valeur d'historique de contrainte correspondante (*n*_{1,1}(*t*), ..., *n*_{P,Q}(t)) exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée, une somme d'endommagement par fatigue (D) basée sur les valeurs de réponse et les valeurs d'historique de contrainte liées aux valeurs de réponse, la somme d'endommagement par fatigue exprimant l'endommagement par fatigue cumulé de la structure mécanique,
dans lequel
- chacune des chacune des valeurs de réponse est associée, en plus de la plage de contraintes prédéterminée et de la contrainte moyenne prédéterminée, à une ou plusieurs quantité(s) décrivant les conditions de fonctionnement de la structure mécanique, et
- l'équipement de traitement est configuré pour mettre à jour chaque valeur d'historique de contrainte pour exprimer le nombre de cycles qui se sont produits dans la tendance temporelle de la contrainte de façon à ce que les cycles qui se sont produits aient la plage de contraintes prédéterminée et la contrainte moyenne prédéterminée liées à la valeur de réponse en considération, et les conditions de fonctionnement de la structure mécanique correspondent à l'une ou les quantité(s) liée(s) à la valeur de réponse en considération.

3. Système de surveillance de la fatigue d'une structure mécanique, **caractérisé en ce que** le système comprend un équipement de mémoire (101) stockant une base de données (102) contenant des valeurs de réponse prédéterminées (*N*_{1,1}, ..., *N*_{P,Q}), chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique, dans lequel le système comprend un équipement de traitement (103) configuré pour :
- mettre à jour de manière répétée, pour chacune des valeurs de réponse, une valeur d'historique de contrainte correspondante (*n*_{1,1}(*t*), ..., *n*_{P,Q}(t)) exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée, une somme d'endommagement par fatigue (D) basée sur les valeurs de réponse et les valeurs d'historique de contrainte liées aux valeurs de réponse, la somme d'endommagement par fatigue exprimant l'endommagement par fatigue cumulé de la structure mécanique,
dans lequel chacune des valeurs de réponse *N_{k,q},* où *k*=1, 2, ..., P et *q* = 1, 2, ..., Q est : ${N}_{k , q} = \frac{{C}_{ref}}{{\left(\frac{Δ {σ}_{q}}{\sqrt{1 - {R}_{local}}}\right)}^{{m}_{ref}}} ,$
où *C_{ref}* est une performance de fatigue spécifique à la structure mécanique et correspond à la probabilité de survie prédéterminée, Δ*σ_{q}* est la plage de contraintes prédéterminée au point d'observation prédéterminé de la structure mécanique et lié à la valeur de réponse *N_{k,q}* et *m*_{ref} est un paramètre de modèle étant une pente d'une courbe S-N, et *R_{local}* est un rapport de contrainte local au point d'observation prédéterminé de la structure mécanique : ${R}_{local} = \frac{{σ}_{mean} - Δ σ / 2}{{σ}_{mean} + Δ σ / 2} ,$
où *σₘₑₐₙ* et Δ*σ* sont une contrainte moyenne et une plage de contraintes au point d'observation de la structure mécanique.

4. Système selon la revendication 1, dans lequel l'équipement de traitement est configuré pour calculer la contrainte de membrane et la contrainte de flexion en se basant sur des résultats (s1(*t*), s2(*t*)) de jauges de contrainte fixées sur la structure mécanique, la contrainte de membrane étant proportionnelle à une moyenne des résultats des jauges de contrainte et la contrainte de flexion étant proportionnelle à une différence des résultats des jauges de contrainte.

5. Système selon la revendication 4, dans lequel le système comprend les jauges de contrainte (104, 105).

6. Système selon l'une quelconque des revendications 1-5, dans lequel l'équipement de traitement est configuré pour calculer la somme d'endommagement par fatigue (D) selon la formule : $D = {\sum }_{i , j} \frac{{n}_{i , j} \left(t\right)}{{N}_{i , j}} ,$ dans laquelle n_{i,j}(*t*) est la valeur d'historique de contrainte exprimant le nombre des cycles qui se sont produits dans la tendance temporelle de la contrainte et ayant la *i*^{ème} plage de contraintes prédéterminée et la *j*^{ème} contrainte moyenne prédéterminée, et *N*_{i,j} est la valeur de réponse liée à la *i*^{ème} plage de contraintes prédéterminée et à la *j*^{ème} contrainte moyenne prédéterminée.

7. Système selon la revendication 2, dans lequel l'une ou les quantité(s) décrivant les conditions de fonctionnement de la structure mécanique comprennent la température de la structure mécanique.

8. Système selon l'une quelconque des revendications 1-7, dans lequel le système comprend un élément d'affichage (106) et l'équipement de traitement est configuré pour commander l'élément d'affichage pour montrer la croissance de la somme d'endommagement par fatigue en fonction du service cumulatif produit par la structure mécanique.

9. Système selon l'une quelconque des revendications 1-8, dans lequel l'équipement de traitement est configuré pour calculer une vitesse de croissance moyenne (223) de la somme d'endommagement par fatigue et pour estimer le service restant (*P*ᵣₑₛ 1,1) productible par la structure mécanique en se basant sur : i) une valeur actuelle (*D*_{curr}) de la somme d'endommagement par fatigue, ii) la vitesse de croissance moyenne de la somme d'endommagement par fatigue et iii) une valeur de la somme d'endommagement par fatigue correspondant à une probabilité d'endommagement prédéterminée.

10. selon l'une quelconque des revendications 1-9, dans lequel l'équipement de traitement est configuré pour calculer une estimation d'une vitesse de croissance instantanée (224) de la somme d'endommagement par fatigue et pour estimer le service restant (*P*ᵣₑₛ 1, 2) productible par la structure mécanique en se basant sur : i) une valeur actuelle (*D*_{curr}) de la somme d'endommagement par fatigue, ii) l'estimation de la vitesse de croissance moyenne de la somme d'endommagement par fatigue et iii) une valeur de la somme d'endommagement par fatigue correspondant à une probabilité d'endommagement prédéterminée.

11. Procédé de surveillance de la fatigue d'une structure mécanique, **caractérisé en ce que** le procédé comprend :
- de maintenir (301) une base de données contenant des valeurs de réponse prédéterminées, chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique,
- mettre à jour de manière répétée (302), pour chacune des valeurs de réponse, une valeur d'historique de contrainte correspondante exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée (303), une somme d'endommagement par fatigue basée sur les valeurs de réponse et les valeurs d'historique de contrainte liées aux valeurs de réponse, la somme d'endommagement par fatigue exprimant l'endommagement par fatigue cumulé de la structure mécanique,
- estimer de manière répétée la contrainte au point d'observation prédéterminé de la structure mécanique en se basant sur des données indiquant la charge mécanique dirigée vers la structure mécanique,
dans lequel la contrainte est calculée en tant qu'une somme pondérée de i) contrainte de membrane (σₘ(ₜ)) et ii) contrainte de flexion (σ_{b}(ₜ)) agissant sur une zone de la structure mécanique à distance du point d'observation prédéterminé de la structure mécanique, des facteurs de poids de la somme pondérée étant des facteurs de concentration de contrainte locale prédéterminés (*K*_{t,m,} K_{t,b}) définis séparément pour les contraintes de membrane et de flexion.

12. Procédé de surveillance de la fatigue d'une structure mécanique, **caractérisé en ce que** le procédé comprend :
- de maintenir (301) une base de données contenant des valeurs de réponse prédéterminées, chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique,
- mettre à jour de manière répétée (302), pour chacune des valeurs de réponse, une valeur d'historique de contrainte correspondante exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée (303), une somme d'endommagement par fatigue basée sur les valeurs de réponse et les valeurs d'historique de contrainte liées aux valeurs de réponse, la somme d'endommagement par fatigue exprimant l'endommagement par fatigue cumulé de la structure mécanique,
dans lequel
- chacune des chacune des valeurs de réponse est associée, en plus de la plage de contraintes prédéterminée et de la contrainte moyenne prédéterminée, à une ou plusieurs quantité(s) décrivant les conditions de fonctionnement de la structure mécanique, et
- chaque valeur d'historique de contrainte est mise à jour pour exprimer le nombre de cycles qui se sont produits dans la tendance temporelle de la contrainte de façon à ce que les cycles qui se sont produits aient la plage de contraintes prédéterminée et la contrainte moyenne prédéterminée liées à la valeur de réponse en considération, et les conditions de fonctionnement de la structure mécanique correspondent à l'une ou les quantité(s) liée(s) à la valeur de réponse en considération.

13. Procédé de surveillance de la fatigue d'une structure mécanique, **caractérisé en ce que** le procédé comprend :
- de maintenir (301) une base de données contenant des valeurs de réponse prédéterminées, chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique,
- mettre à jour de manière répétée (302), pour chacune des valeurs de réponse, une valeur d'historique de contrainte correspondante exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée (303), une somme d'endommagement par fatigue basée sur les valeurs de réponse et les valeurs d'historique de contrainte liées aux valeurs de réponse, la somme d'endommagement par fatigue exprimant l'endommagement par fatigue cumulé de la structure mécanique,
dans lequel chacune des valeurs de réponse *N_{k,q,}*où *k*=1, 2, ..., P et q = 1, 2, ..., Q est : ${N}_{k , q} = \frac{{C}_{ref}}{{\left(\frac{Δ {σ}_{q}}{\sqrt{1 - {R}_{local}}}\right)}^{{m}_{ref}}} ,$
où *C_{ref}* est une performance de fatigue spécifique à la structure mécanique et correspond à la probabilité de survie prédéterminée, Δ*σ_{q}* est la plage de contraintes prédéterminée au point d'observation prédéterminé de la structure mécanique et lié à la valeur de réponse *N_{k,q}* et *m_{ref}* est un paramètre de modèle étant une pente d'une courbe S-N, et *R_{local}* est un rapport de contrainte local au point d'observation prédéterminé de la structure mécanique : ${R}_{local} = \frac{{σ}_{mean} - Δ σ / 2}{{σ}_{mean} + Δ σ / 2} ,$
où *σₘₑₐₙ* et Δ*σ* sont une contrainte moyenne et une plage de contraintes au point d'observation de la structure mécanique.

14. Programme informatique pour la surveillance de la fatigue d'une structure mécanique, **caractérisé en ce que** le programme informatique comprend des instructions exécutables sur ordinateur pour commander un équipement de traitement programmable à :
- récupérer des données d'une base de données contenant des valeurs de réponse prédéterminées, chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique,
- mettre à jour de manière répétée, pour chacune des valeurs de réponse, une valeur d'historique de contrainte correspondante exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée, une somme d'endommagement par fatigue basée sur les valeurs de réponse et les valeurs d'historique de contrainte liées aux valeurs de réponse, la somme d'endommagement par fatigue exprimantl'endommagement par fatigue cumulé de la structure mécanique,
- estimer de manière répétée la contrainte au point d'observation prédéterminé de la structure mécanique en se basant sur des données indiquant la charge mécanique dirigée vers la structure mécanique,
dans lequel le programme informatique comprend des instructions exécutables sur ordinateur pour commander l'équipement de traitement programmable à calculer la contrainte en tant qu'une somme pondérée de i) contrainte de membrane (σₘ(ₜ)) et ii) contrainte de flexion (σ_{b}(ₜ)) agissant sur une zone de la structure mécanique à distance du point d'observation prédéterminé de la structure mécanique, des facteurs de poids de la somme pondérée étant des facteurs de concentration de contrainte locale prédéterminés (*K*_{t,m,} K_{t,b}) définis séparément pour les contraintes de membrane et de flexion.

15. Programme informatique pour la surveillance de la fatigue d'une structure mécanique, **caractérisé en ce que** le programme informatique comprend des instructions exécutables sur ordinateur pour commander un équipement de traitement programmable à :
- récupérer des données d'une base de données contenant des valeurs de réponse prédéterminées, chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique,
- mettre à jour de manière répétée, pour chacune des valeurs de réponse, une valeur d'historique de contrainte correspondante exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée, une somme d'endommagement par fatigue basée sur les valeurs de réponse et les valeurs d'historique de contrainte liées aux valeurs de réponse, la somme d'endommagement par fatigue exprimant l'endommagement par fatigue cumulé de la structure mécanique,
dans lequel :
- chacune des chacune des valeurs de réponse est associée, en plus de la plage de contraintes prédéterminée et de la contrainte moyenne prédéterminée, à une ou plusieurs quantité(s) décrivant les conditions de fonctionnement de la structure mécanique, et
- le programme informatique comprend des instructions exécutables sur ordinateur pour commander l'équipement de traitement programmable à mettre à jour chaque valeur d'historique de contrainte pour exprimer le nombre de cycles qui se sont produits dans la tendance temporelle de la contrainte de façon à ce que les cycles qui se sont produits aient la plage de contraintes prédéterminée et la contrainte moyenne prédéterminée liées à la valeur de réponse en considération, et les conditions de fonctionnement de la structure mécanique correspondent à l'une ou les quantité(s) liée(s) à la valeur de réponse en considération.

16. Programme informatique pour la surveillance de la fatigue d'une structure mécanique, **caractérisé en ce que** le programme informatique comprend des instructions exécutables sur ordinateur pour commander l'équipement de traitement programmable à :
- récupérer des données d'une base de données contenant des valeurs de réponse prédéterminées, chacune étant associée à une de plages de contraintes prédéterminées et une de contraintes moyennes prédéterminées, chacune des valeurs de réponse exprimant une limite supérieure d'un nombre de cycles de contraintes à un point d'observation prédéterminé de la structure mécanique dans une situation dans laquelle les cycles ont la plage de contraintes prédéterminée et la contrainte moyenne prédéterminée liées à la valeur de réponse en considération, la limite supérieure correspondant à une probabilité de survie prédéterminée de la structure mécanique,
- mettre à jour de manière répétée, pour chacune des valeurs de réponse, une valeur d'historique de contrainte correspondante exprimant un nombre de cycles qui se sont produits dans une tendance temporelle de la contrainte et ayant la plage de contraintes prédéterminée et la contrainte moyenne prédéterminée liées à la valeur de réponse en considération, et
- mettre à jour de manière répétée, une somme d'endommagement par fatigue basée sur les valeurs de réponse et les valeurs d'historique de contrainte liées aux valeurs de réponse, la somme d'endommagement par fatigue exprimant l'endommagement par fatigue cumulé de la structure mécanique,
dans lequel dans lequel chacune des valeurs de réponse *N_{k,q,}*où *k*=1, 2, ..., P et *q =* 1, 2, ..., Q est : ${N}_{k , q} = \frac{{C}_{ref}}{{\left(\frac{Δ {σ}_{q}}{\sqrt{1 - {R}_{local}}}\right)}^{{m}_{ref}}} ,$
où *C_{ref}* est une performance de fatigue spécifique à la structure mécanique et correspond à la probabilité de survie prédéterminée, Δσ*_{q}* est la plage de contraintes prédéterminée au point d'observation prédéterminé de la structure mécanique et lié à la valeur de réponse *N_{k,q}* et *m_{ref}* est un paramètre de modèle étant une pente d'une courbe S-N, et *R_{local}* est un rapport de contrainte local au point d'observation prédéterminé de la structure mécanique : ${R}_{local} = \frac{{σ}_{mean} - Δ σ / 2}{{σ}_{mean} + Δ σ / 2} ,$
où *σₘₑₐₙ* et Δ*σ* sont une contrainte moyenne et une plage de contraintes au point d'observation de la structure mécanique.
